Europäisches Patentamt

European Patent Office

Office européen des brevets

(19)

(11) Publication number: **0 025 289**
**B1**

## (12) EUROPEAN PATENT SPECIFICATION

(45) Date of publication of patent specification: **09.11.83**

(21) Application number: **80302840.6**

(22) Date of filing: **18.08.80**

(51) Int. Cl.³: **G 11 C 11/40,** G 1 1 C 7/02, H 01 L 27/06

(54) Semiconductor memory device with multi-emitter transistor cells.

(30) Priority: **23.08.79 JP 107393/79**

(43) Date of publication of application:
**18.03.81 Bulletin 81/11**

(45) Publication of the grant of the patent:
**09.11.83 Bulletin 83/45**

(84) Designated Contracting States:
**DE FR GB NL**

(56) References cited:
EP - A - 0 011 405
DE - B - 2 740 565
US - A - 3 465 213
US - A - 3 628 069
US - A - 3 810 123
US - A - 4 117 545

(73) Proprietor: **FUJITSU LIMITED**
**1015, Kamikodanaka Nakahara-ku**
**Kawasaki-shi Kanagawa 211 (JP)**

(72) Inventor: **Isogai, Hideaki**
**4-11-13, Minamisawa Higashikurume-shi**
**Tokyo 180-03 (JP)**

(74) Representative: **Abbott, Leonard Charles et al,**
**GILL JENNINGS & EVERY 53-64 Chancery Lane**
**London WC2A 1HN (GB)**

(56) References cited:
**IEEE JOURNAL OF SOLID-STATE CIRCUITS,
vol. SC9, no. 5, October 1974, pages 283—284
New York, U.S.A. H. MAYUMI et al.: "A 25-ns
Read Access Bipolar 1 kbit TTL RAM"
SIEMENS FORSCHUNGS &
ENTWICKLUNGSBERICHT, vol. 6, no. 2, 1977,
pages 86—91 München, DE. H. ERNST et al.: "A
Fast Bipolar 1024-bit RAM for High-
Performance Memory Systems"
IEEE JOURNAL OF SOLID-STATE CIRCUITS,
vol. SC-13, no. 5, October 1978, pages 656—
663 New York, U.S.A. K. KAWARADA et al.: "A
Fast 7.5 ns Access 1K-Bit RAM for Cache-
Memory Systems"**

Courier Press, Leamington Spa, England.

Semiconductor memory device with multi-emitter transistor cells

The present invention relates to a semiconductor memory device, more especially to an improvement of a semiconductor memory device which has memory cells formed by a pair of multi-emitter transistors each having a collector and a base cross-connected to each other and read out transistors having emitters connected to one of the emitters of the multi-emitter transistors.

There has been a tendency for the size of memory cells forming a semiconductor memory device to decrease with increase of the memory capacity of the semiconductor memory device. When the size of memory cells is decreased, the characteristics of a transistor forming part of a memory cell are affected by a dispersion of the transistor which is caused by the manufacturing process. For example, as a width of a window for an electrode such as an emitter electrode varies, or the size of the window for an electrode varies, due to the manufacturing process, a forward current of the diode between a base and an emitter of the transistor varies. If the position of the window for the electrode varies from a correct position, the base resistance of the transistor varies. When the characteristics of the transistors which form the memory cells vary due to the manufacturing process, as described above, sometimes information stored in the memory cells cannot be read out or the information may be destroyed.

An object of the present invention is to provide a semiconductor memory device which is less affected by a variation of the characteristics of the transistor.

In US—A—4 117 545 a semiconductor memory using a differential sense amplifier and dummy cells is disclosed. The structure of the memory and dummy cells, and their positions relative to the word and data lines, is such that the effects on the memory cells due to misalignment of the mask used in manufacture of the word lines is the same as the effects on the dummy cells. This allows noise cancellation in the sense amplifier even in the case of such mask misalignment.

The present invention consists in a semiconductor memory device comprising memory cells arranged in row and column directions and each formed by a pair of multi-emitter transistors having cross-connected collectors and bases, each column having a read-out transistor having an emitter which is commonly connected to one of the emitters of the multi-emitter transistors, each multi-emitter transistor and read-out transistor having a characteristic which varies with the position of an emitter region relative to another region, and characterized in that the position of the emitter region relative to the said other region in each read-out transistor is the same as the position of the emitter to which that read-out transistor is connected in the multi-emitter transistor relative to the said other region of that multi-emitter transistor.

The read out transistors may be multi-emitter transistors having emitters connected to bit lines of different columns. The achievement of the same change in the characteristics of the multi-emitter transistors and their related read out transistors may be caused by the relative positions of the emitter and base in the multi-emitter transistors of the memory cells and in the read out transistors, or may be caused by similar relative positioning of the emitter and isolation region in the multi-emitter transistors of the memory cells and in the read out transistors.

Further features and advantages of the present invention will be apparent from the ensuing description with reference to the accompanying drawings to which, however, the scope of the invention is in no way limited.

Fig. 1 illustrates a circuit of an example of a conventional semiconductor memory device;

Fig. 2 illustrates a circuit of one embodiment of a semiconductor memory device according to the present invention;

Fig. 3A and 3B illustrate a plan view of one embodiment of the transistor used in the circuit illustrated in Fig. 2 and a cross-sectional view of an essential portion of said transistors, respectively,

Figs. 4A and 4B illustrate a plan view of another embodiment of a transistor used in the circuit illustrated in Fig. 2 and a cross-sectional view of an essential portion of said transistor.

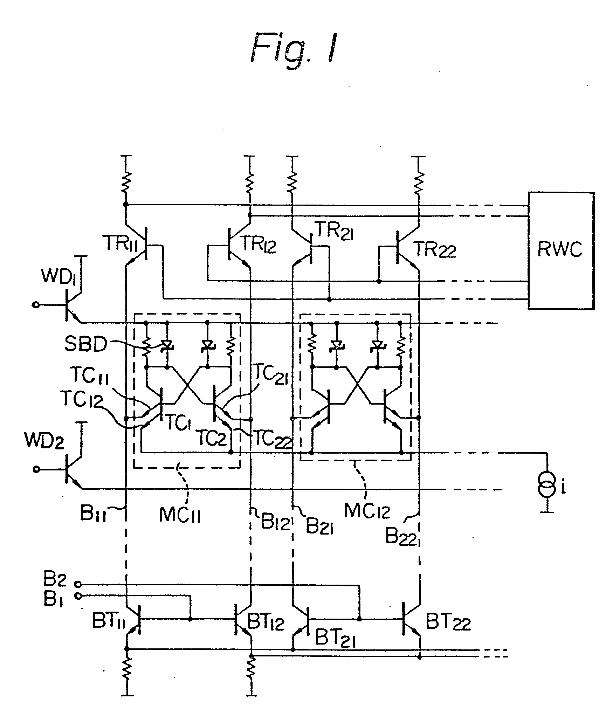

Fig. 1 illustrates a circuit of a conventional semiconductor memory device, and a plurality of memory cells MC11, MC12, . . ., are arranged in a row direction and a column direction as illustrated in Fig. 1. Referring to Fig. 1, WD1, WD2, . . ., denote row selection means which select the memory cells MC11, MC12, . . ., arranged in the row direction, and $B_1$, $B_2$, . . ., $BT_{11}$, $BT_{12}$, . . ., denote column selection means which select the memory cells $MC_{11}$, $MC_{12}$, . . ., arranged in the column direction. Read-out transistors $TR_{11}$, $TR_{12}$, $TR_{21}$, $TR_{22}$, . . ., are provided in each column so as to read out information stored in the memory cells $MC_{11}$, $MC_{12}$, . . . These read out transistors $TR_{11}$, $TR_{12}$, $TR_{21}$, $TR_{22}$, . . ., are also used for writing information into the memory cells $MC_{11}$, $MC_{12}$, . . ., RWC denotes a read and write circuit. As is well known, the memory cells $MC_{11}$, $MC_{12}$ are formed by multi-emitter transistors $TC_1$ and $TC_2$ which form a flip-flop circuit. Emitters $TC_{12}$, $TC_{22}$ of the multi-emitter transistors $TC_1$ and $TC_2$ are connected to a current source i for holding the information in the memory cells, and emitters $TC_{11}$, $TC_{21}$ of the multi-emitter

transistors $TC_1$, $TC_2$ are connected to bit lines $B_{11}$ and $B_{12}$ respectively.

An operation of the circuit illustrated in Fig. 1 is as described below.

If the row selection means $WD_1$ and the column selection means $B_1$ are selected, the memory cell $MC_{11}$ is selected. In a case where in the memory cell $MC_{11}$ the transistor $TC_1$ is an on state and the transistor $TC_2$ is an off state, a current which flows from the emitter $TC_{12}$ to the current source i is changed to a current which flows from the emitter $TC_{11}$ to the bit line $B_{11}$. The emitter of the readout transistor $TR_{11}$ is coupled to the emitter $TC_{11}$ of the transistor $TC_1$ and the emitter of the read-out transistor $TR_{12}$ is coupled to the emitter $TC_{21}$ of the transistor $TC_2$ so as to operate as a current switch. Therefore, the current from the emitter $TC_{11}$ of the transistor $TC_1$ flows in the bit line $B_{11}$ and the current from the emitter of the read out transistor $TR_{12}$ flows in the bit line $B_{12}$. Accordingly, the collector of the read-out transistor $TR_{11}$ is placed in a high potential level and the collector of the read-out transistor $TR_{12}$ is placed in a low potential level, so that the content of the memory cell $MC_{11}$ is read out by the read and write circuit RWC.

In the semiconductor memory device illustrated in Fig. 1, the transistors $TC_1$ and $TC_2$ and the read out transistors $TR_{11}$ and $TR_{12}$ have emitters coupled respectively and operated as a current switch. However, the characteristics of the transistors $TC_1$, $TC_2$ and the read out transistors $TR_{11}$, $TR_{12}$ vary during the manufacturing process. For example, if the size of the window for an emitter electrode varies during the manufacturing process, forward currents through the base and the emitter of the transistors $TC_1$, $TC_2$, $TR_{11}$, $TR_{12}$ disperse, or if said window for the electrode is not at the correct position, the base resistance or the current amplification factor disperses. If the characteristics of the read out transistors $TR_{11}$, $TR_{12}$ and the transistors $TC_1$, $TC_2$ in the memory cell $MC_{11}$ are different, it may not always be possible to correctly read out information stored in the memory cells and said information may even be destroyed.

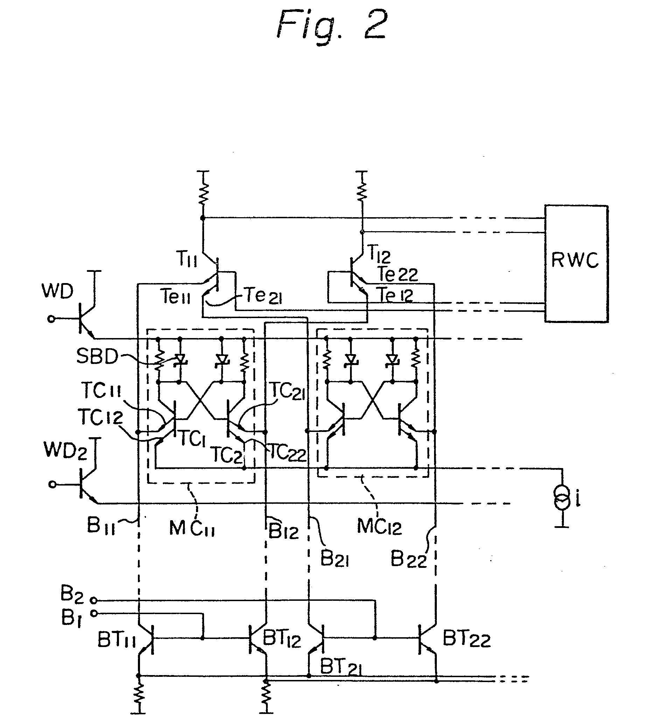

Fig. 2 illustrates a circuit of one embodiment of the semiconductor memory device according to the present invention, and referring to Fig. 2, portions corresponding to portions illustrated in Fig. 1 are designated by the same symbols as those used in Fig. 1.

The circuit illustrated in Fig. 2 is different from the circuit illustrated in Fig. 1, in that read out transistors $T_{11}$, $T_{12}$ are formed by a multi-emitter transistor, and emitters $Te_{11}$, $Te_{12}$ of the read out transistors $T_{11}$, $T_{12}$ are connected to the bit lines $B_{11}$ and $B_{12}$ respectively and emitters $Te_{12}$, $Te_{22}$ of the read out transistor $T_{11}$, $T_{12}$ are connected to bit lines $B_{21}$, $B_{22}$ respectively.

In the circuit illustrated in Fig. 2, the read out transistors $TR_{11}$, $TR_{12}$, $TR_{21}$, $TR_{22}$ illustrated in Fig. 1 are replaced by the multi-emitter transistors $T_{11}$ and $T_{12}$, and therefore, the operation of the circuit illustrated in Fig. 2 is quite similar to the circuit illustrated in Fig. 1. Therefore, the operation of the circuit illustrated in Fig. 2 is omitted herein.

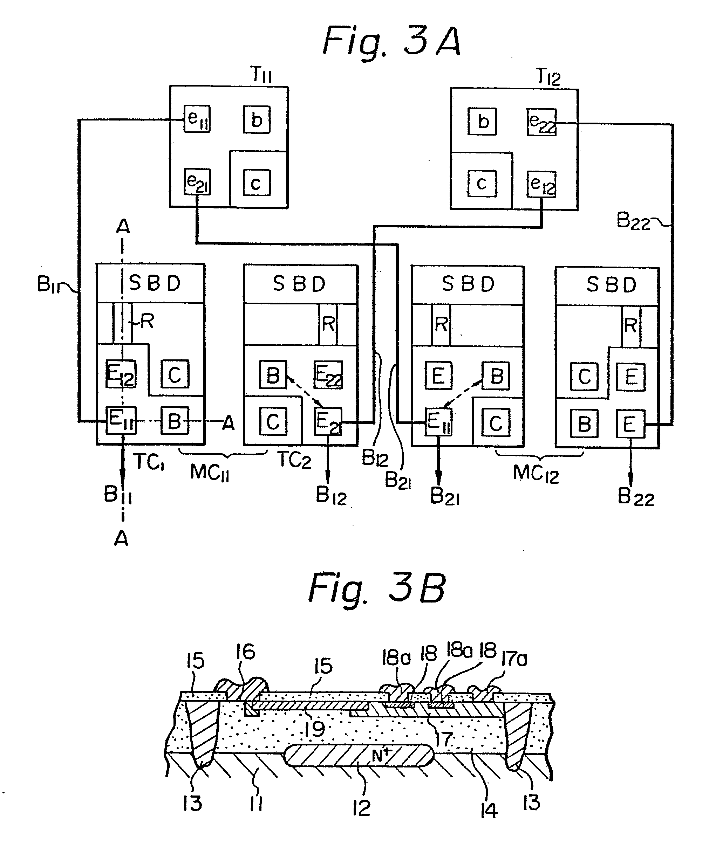

Fig. 3A illustrates a plan view of one embodiment of the transistor used in the circuit illustrated in Fig. 2, and a cross-sectional view along A—A of Fig. 3A is illustrated in Fig. 3B. In Fig. 3A, the relation among the memory cells $MC_{11}$, $MC_{12}$, the read-out transistors $T_{11}$, $T_{12}$ and the bitlines $B_{11}$, $B_{12}$, $B_{21}$, $B_{22}$ are illustrated. Referring to Fig. 3A, $e_{11}$, $e_{21}$, $e_{12}$ and $e_{22}$ in the read out transistors $T_{11}$ and $T_{12}$ correspond, respectively, to the emitters $Te_{11}$, $Te_{21}$, $Te_{12}$, $Te_{22}$ of the transistors $T_{11}$ and $T_{12}$, b and c in the transistors $T_{11}$ and $T_{12}$ respectively denote a base and collector of the transistors $T_{11}$ and $T_{12}$. $E_{11}$, $E_{12}$, $E_{21}$ and $E_{22}$ of the memory cell $MC_{11}$ correspond to the emitters $TC_{11}$, $TC_{12}$, $TC_{21}$, and $TC_{22}$ of the transistors $TC_1$, $TC_2$ respectively, and B and C in the memory cell $MC_{11}$ correspond to the base and the collector of the transistors $TC_1$ and $TC_2$ respectively. Further, in Fig. 3A, SBD denotes a Shottky barrier diode, and R denotes a resistor.

Referring to Fig. 3B, 11 denotes a substrate, 12 denotes a buried layer, 13 denotes an isolation region, 14 denotes a collector region, 15 denotes an insulation layer, 16 denotes a Shottky Barrier diode corresponding to the SBD of Fig. 3A, 17 denotes a base region, 17a denotes a base electrode corresponding to the base B of Fig. 3A, 18 denotes an emitter region, 18a denotes an emitter electrode corresponding to one of the emitters $e_{11}$ or $e_{12}$ of Fig. 3A and 19 denotes a resistor corresponding to the resistor R of Fig. 3A.

A major advantage of the construction illustrated in Fig. 3A is compensation of the variation of the distance between the base B and the emitter $E_{21}$ in the cell $MC_{11}$ and a variation of the distance between the base B and the emitter $E_{11}$ of the memory cell $MC_{12}$. As can be understood from Fig. 3A, the construction of transistor $TC_2$ in each memory cell $MC_{11}$ is the same as read-out transistor $T_{12}$ and the construction of the left-hand transistor in each memory cell $MC_{12}$ is the same as read-out transistor $T_{11}$. Moreover, the relative positions of base b, B and emitter $e_{11}$, $E_{11}$ regions in read-out transistor $T_{11}$ and multi-emitter transistors $TC_1$ are the same, as are the base b, B and emitter $e_{22}$, $E_{22}$ regions in read-out transistor $T_{12}$ and the right-hand multi-emitter transistor in each memory cell $MC_{12}$. Therefore, if the position or size of the electrode window varies due to the dispersion caused by the manufacturing process, so that the characteristics of the transistor varies, the construction of the read out transistors $T_{11}$ and $T_{12}$ becomes equivalent in many aspects to the construction of the transistors which form the memory cells $MC_{11}$ and $MC_{12}$, so that a variation of the characteristics of the transistors can be compensated. More particularly, the variation of the base resistance (b—$e_{21}$), due to the distance between the base and the emitter, of the read out transistor having the emitter connected to the bit line $B_{21}$, becomes equivalent to the variation of the base resistance (B, $E_{11}$) of the transistors in the memory cells which have emitters commonly connected to the bit line $B_{21}$. Furthermore, the transistors which have emitters commonly connected to the bit line $B_{12}$, are varied in a similar fashion. Therefore, a read out of the information is not disadvantageously affected and destruction of said information can be prevented.

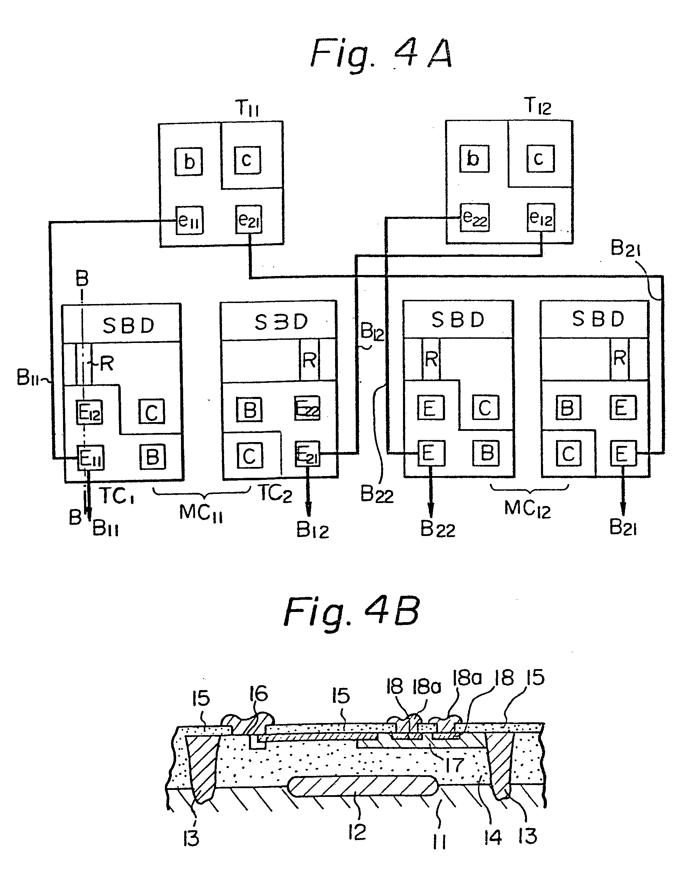

Fig. 4A illustrates a plan view of another embodiment of the transistor used in the circuit illustrated in Fig. 2 and a cross-sectional view along line B—B of Fig. 4A is illustrated in Fig. 4B. Referring to Figs. 4A and 4B, portions corresponding to portions illustrated in Figs. 3A and 3B are designated by the same symbols.

The advantage of the construction illustrated in Fig. 4A is in compensation for the dispersion of the current amplification factor of the transistor due to the position of the emitter near an isolation region. As can be understood from Fig. 4A, the transistors in the memory cells $MC_{11}$ and $MC_{12}$ are constructed in the same manufacturing process as the read out transistors $T_{11}$ and $T_{12}$. Therefore, if the position of the emitter varies due to the dispersion caused by the manufacturing process, so that the current amplification factor of each memory cell transistor varies, the positions of the common emitters of the corresponding read out transistors $T_{11}$ and $T_{12}$ vary so as to compensate. Thus memory cell transistors having emitters commonly connected to the same bit line as the corresponding emitters of read out transistors $T_{11}$ and $T_{12}$, are compensated against the variation of the current amplification factor. Therefore, a read out of information is not disadvantageously affected, and destruction of said information can be prevented.

As mentioned above, a semiconductor memory device includes a plurality of memory cells arranged in row and column directions, selection means for selecting the row and column and read out transistors which are provided in each column for reading out the information stored in the memory cells. According to the features of the present embodiment, the read out transistors and the transistors in the memory cells, which have emitters commonly connected to a common bit line, are formed by the same construction. Therefore, if the characteristics of the transistor vary due to the manufacturing process, the characteristics of the transistors in the memory cells can provide the same characteristics as read out transistors so that neither read out nor retention of the information of the memory cells is adversely affected.

In the embodiment illustrated in Fig. 2, the emitters $Te_{11}$, $Te_{12}$, $Te_{21}$ and $Te_{22}$ for the read out transistors $T_{11}$, and $T_{12}$ are connected to the two column bit lines $B_{11}$, $B_{12}$, $B_{21}$ and $B_{22}$, respectively. However, it is understood that the same effect of the present invention can be expected in a case when a transistor having one emitter is used as the read out transistor, the emitter of which is connected to a column bit line of the memory matrix such as the bit line $B_{11}$, as is obtained in the case when multi-emitter transistors are used as the read out transistors, the emitters of which are connected to two column bit lines such as the bit lines $B_{12}$ and $B_{21}$.

## Claims

1. A semiconductor memory device comprising memory cells ($MC_{11}$, $MC_{12}$) arranged in row and column directions and each formed by a pair of multi-emitter transistors ($TC_1$, $TC_2$) having cross-connected collectors and bases, each column having a read-out transistor ($T_{11}$, $T_{12}$) having an emitter which is commonly connected to one of the emitters of the multi-emitter transistors, each multi-emitter transistor and read out transistor having a characteristic which varies with the position of an emitter region relative to another region, and characterized in that the position of the emitter region ($e_{21}$) relative to the said other region (b) in each read-out transistor ($T_{11}$) is the same as the position of the emitter ($E_{11}$) to which that read-out transistor is connected in the multi-emitter transistor relative to the said other region (B) of that multi-emitter transistor.

2. A semiconductor memory device in accordance with claim 1, wherein each read-out transistor ($T_{11}$, $T_{12}$, Fig. 3A) is formed so that the relative position of its emitter region, base region, collector region and isolation region, which determine the transistors characteristics, are the same as those of one multi-emitter transistor with which it has a common emitter connection.

3. A semiconductor memory device according to claim 1 or 2, wherein the position of the emitter relative to the base in each read-out transistor is the same as the position of the emitter to which that read-out transistor is connected in the multi-emitter transistor relative to the base of that multi-emitter transistor.

4. A semiconductor memory device in accordance with claim 1, wherein each read-out transistor and each multi-emitter transistor of the memory cells has an isolation region, the position of the emitter relative to the isolation region in each read-out transistor being the same as the position of the emitter to which that read-out transistor is connected in the multi-emitter transistor relative to the isolation region of that multi-emitter transistor.

5. A semiconductor memory device in accordance with any of claims 1 to 4 wherein at least some of the read-out transistors are multi-

emitter transistors ($T_{11}$, $T_{12}$), each read-out multi-emitter transistor ($T_{11}$) having its emitter connected to bit lines ($B_{11}$, $B_{21}$) of different memory cells.

6. A semiconductor memory device in accordance with claim 5, wherein two multi-emitter read-out transistors ($T_{11}$, $T_{12}$) serve for two adjacent columns of memory cells, each multi-emitter read-out transistor having different emitters connected to bit lines of different ones of said two columns.

## Patentansprüche

1. Halbleiterspeichervorrichtung mit in Reihen und Spalten angeordneten Speicherzellen ($MC_{11}$, $MC_{12}$), welche jeweils durch ein Paar von Mehremittertransistoren ($TC_1$, $TC_2$) gebildet werden, deren Basen und Kollektoren über Kreuz miteinander verbunden sind, wobei jede Spalte einen Lesetransistor ($T_{11}$, $T_{12}$) mit einem Emitter hat, der gemeinsam mit einem der Emitter der Mehremittertransistoren verbunden ist, und jeder Mehremittertransistor und Lesetransistor eine Charakteristik hat, welche sich entsprechend der Position einer Emitterzone relativ zu einer anderen Zone ändert, und dadurch gekennzeichnet, daß die Position der Emitterzone ($e_{21}$) relativ zu dem genannten anderen Bereich (b) in jedem Lesetransistor ($T_{11}$) dieselbe ist, wie die Position des Emitters ($E_{11}$) in dem Mehremittertransistor, mit welchem der Lesetransistor verbunden ist, relativ zu dem genannten anderen Bereich (B) des Mehremittertransistors.

2. Halbleiterspeichervorrichtung nach Anspruch 1, bei welcher jeder Lesetransistor ($T_{11}$, $T_{12}$, Fig. 3A) so ausgebildet ist, daß die relativen Positionen seiner Emitterzone, seiner Basiszone, seiner Kollektorzone und seiner Isolierungszone, welche die Charakteristiken des Transistors bestimmen, dieselben sind, wie diejenige eines Mehremittertransistors, mit welchem er einen gemeinsamen Emitteranschluß hat.

3. Halbleiterspeichervorrichtung nach Anspruch 1 oder 2, bei welcher die Position des Emitters relativ zur Basis in jedem Lesetransistor dieselbe ist wie die Position des Emitters in dem Mehremittertransistor, mit welchem der Lesetransistor verbunden ist, relativ zu der Basis des Mehremittertransistors.

4. Halbleiterspeichervorrichtung nach Anspruch 1, bei welcher jeder Lesetransistor und jeder Mehremittertransistor der Speicherzellen eine Isolierungszone aufweist, bei welcher die Position des Emitters relativ zu der Isolierungszone in jedem Lesetransistor dieselbe ist wie die Position des Emitters in dem Mehremittertransistor, mit welchem dieser Lesetransistor verbunden ist, relativ zu der Isolierungszone diese Mehremittertransistors.

5. Halbeleiterspeichervorrichtung nach einem der Ansprüche 1 bis 4, bei welcher wenigstens einige der Lesetransistoren Mehr-

emittertransistoren ($T_{11}$, $T_{12}$) sind, wobei der Emitter jedes Mehremitterlesetransistors ($T_{11}$) mit Bitleitungen ($B_{11}$, $B_{12}$) von verschiedenen Speicherzellen verbunden ist.

6. Halbleiterspeichervorrichtung nach Anspruch 5, bei welchem zwei Mehremitterlesetransistoren ($T_{11}$, $T_{12}$) für zwei benachbarte Spalten der Speicherzellen vorgesehen sind, wobei jeder Mehremitterlesetransistor verschiedene Emitter hat, welche mit Bitleitungen von verschiedenen der beiden Spalten verbunden sind.

## Revendications

1. Dispositif de mémorisation à semi-conducteurs comprenant des cellules de mémorisation ($MC_{11}$, $MC_{12}$) disposées en rangées et en colonnes et formées chacune d'une paire de transistors de type multi-émetteur ($TC_1$, $TC_2$) dont les collecteurs et les bases sont connectés en croix, chaque colonne possédant un transistor de lecture ($T_{11}$, $T_{12}$) ayant un émetteur qui est connecté en commun à l'un des émetteurs des transistors du type multi-émetteur, chaque transistor du type multi-émetteur et chaque transistor de lecture présentant une caractéristique qui varie avec la position d'une région d'émetteur par rapport à une autre région, et caractérisé en ce que la position de la région d'émetteur ($e_{21}$) par rapport à ladite autre région (*b*) dans chaque transistor de lecture ($T_{11}$) est la même que la position de l'émetteur ($E_{11}$) auquel ce transistor de lecture est connecté dans le transistor du type multi-émetteur par rapport à ladite autre région (B) de ce transistor du type multi-émetteur.

2. Dispositif de mémorisation à semi-conducteurs selon la revendication 1, où chaque transistor de lecture ($T_{11}$, $T_{12}$, figure 3A) est formé de façon que les positions relatives de sa région d'émetteur, de sa région de base, de sa région de collecteur et de sa région isolation, qui déterminent les caractéristiques du transistor, sont les mêmes que celles d'un transistor du type multi-émetteur avec lequel il a une connexion d'émetteur commune.

3. Dispositif de mémorisation à semi-conducteurs selon la revendication 1 ou 2, où la position de l'émetteur par rapport à la base dans chaque transistor de lecture est la même que la position de l'émetteur, auquel ce transistor de lecture est connecté, dans le transistor du type multi-émetteur par rapport à la base de ce transistor multi-émetteur.

4. Dispositif de mémorisation à semi-conducteurs selon la revendication 1, où chaque transistor de lecture et chaque transistor du type multi-émetteur des cellules de mémorisation possèdent une région d'isolation, la position de l'émetteur par rapport à la région d'isolation dans chaque transistor de lecture étant la même que la position de l'émetteur, auquel ce transistor de lecture est connecté, dans le transistor du type multi-émetteur par rapport à la région d'isolation de ce transistor du type multi-émetteur.

5. Dispositif de mémorisation à semi-conducteurs selon l'une quelconque des revendications 1 à 4, où au moins certain des transistors de lecture sont des transistors du type multi-émetteur ($T_{11}$, $T_{12}$), chaque transistor du type multi-émetteur de lecture ($T_{11}$) ayant son émetteur connecté aux lignes de bit ($B_{11}$, $B_{12}$) de différentes cellules de mémorisation.

6. Dispositif de mémorisation à semi-conducteurs selon la revendication 5, où deux transistors de lecture du type multi-émetteur ($T_{11}$, $T_{12}$) desservent deux colonnes adjacentes de cellules de mémorisation, chaque transistor de lecture du type multi-émetteur possédant des émetteurs différents connectés aux lignes de bit de colonnes différentes desdits deux colonnes.

# Fig. 1

# Fig. 2

# Fig. 3A

# Fig. 3B

# Fig. 4 A

# Fig. 4B